# EUROPÄISCHE PATENTSCHRIFT

(11) **EP 1 532 723 B1**
(45) Veröffentlichungstag und Bekanntmachung des Hinweises auf die Patenterteilung: **20.12.2006**
(21) Anmeldenummer: 03794867.6
(22) Anmeldetag: 11.08.2003
(51) Int. Cl.: H02K 11/04

(54) **ANORDNUNG ZUR UNTERBRINGUNG DER LEISTUNGS- UND STEUERELEKTRONIK EINES ELEKTROMOTORS**
ASSEMBLY FOR ACCOMMODATING THE POWER ELECTRONICS AND CONTROL ELECTRONICS OF AN ELECTRIC MOTOR
SYSTEME DESTINE A RENFERMER L'ELECTRONIQUE DE PUISSANCE ET L'ELECTRONIQUE DE COMMANDE D'UN MOTEUR ELECTRIQUE

(30) Priorität: 28.08.2002 DE 10239512
(43) Veröffentlichungstag der Anmeldung: 25.05.2005
(73) Patentinhaber: MINEBEA Co., Ltd., Kitasaku-gun, Nagano-ken (JP)
(72) Erfinder: RATHMANN, Robert, 83024 Rosenheim (DE)
(74) Vertreter: Liesegang, Eva
(86) Internationale Anmeldenummer: PCT/EP2003/008896
(87) Internationale Veröffentlichungsnummer: WO 2004/025812

(56) Entgegenhaltungen:
- EP-A- 0 951 131
- WO-A-98/58825
- DE-A- 19 636 723
- DE-A- 19 949 914
- US-A- 5 532 533
- US-A- 5 825 107
- US-A1- 2001 015 583

## Beschreibung

Die Erfindung betrifft eine Gehäuseanordnung zur Aufnahme der Leistungs- und Steuerelektronik eines Elektromotors, wobei diese Gehäuseanordnung auch den Elektromotor selbst mit einbeziehen kann. Die Erfindung betrifft spezieller eine Anordnung gemäß dem Oberbegriff von Patentanspruch 1 (DE 199 49 914 A).

Die Erfindung betrifft allgemein das Gebiet der elektronisch kommutierten, bürstenlosen Gleichstrommotoren. Solche Motoren können in unterschiedlichsten Bereichen zur Anwendung kommen, beispielsweise in der Automobiltechnik für Gebläse, Kühlpumpen oder zur Unterstützung des Lenksystems. Andere Bereiche sind z.B. Lüftergebläse in Netzteilen, oder Spindelmotoren in Plattenlaufwerken für Datenverarbeitungsanlagen, um nur einige wenige Beispiele zu nennen.

Ein elektronisch kommutierter, bürstenloser Gleichstrommotor umfaßt grundsätzlich eine Welle, eine Rotorbaugruppe, die einen oder mehrere auf der Welle angeordneten Permanentmagneten aufweist, und eine Statorbaugruppe, die einen Statorkörper und Phasenwicklungen umfaßt. Zwei Lager sind mit axialem Abstand an der Welle angeordnet, um die Rotorbaugruppe und die Statorbaugruppe relativ zueinander zu lagern.

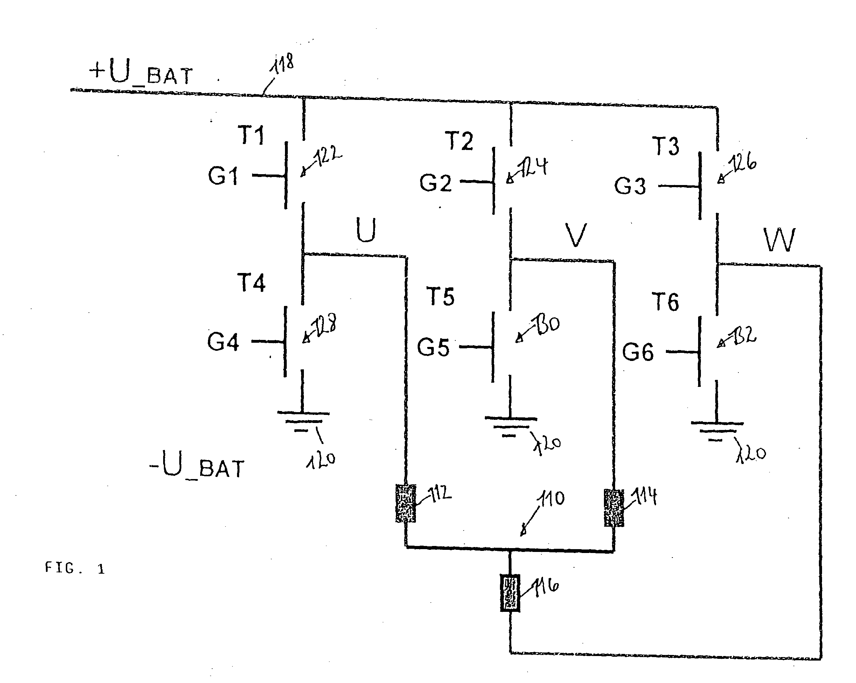

Fig. 1 zeigt schematisch ein Schaltbild einer Schaltung zur Ansteuerung eines dreiphasigen Gleichstrommotors. Die Ansteuerschaltung umfaßt bei dem gezeigten Beispiel sechs Leistungstransistoren sowie weitere, in der Figur nicht gezeigte Ansteuerelektronik, die den Betrieb des Gleichstrommotors kontrollieren. Im Stand der Technik ist es üblich, die Ansteuerelektronik für den Gleichstrommotor auf einer gedruckten Leiterplatte als eine in sich abgeschlossene Einheit aufzubauen, die an den Motor angesteckt oder auf andere Weise mit dem Motor verbunden wird. Die Verbindung zwischen der Elektronik-Leiterplatte und dem Motor wird über Anschlußdrähte und Leitungen hergestellt, die mit der Leiterplatte durch Löten, Stecken oder dergleichen verbunden werden. Steck- und Lötverbindungen sowie die Leitungslängen zwischen dem Motor und der Elektronik-Leiterplatten erhöhen den elektrischen Widerstand des Gleichstrommotors und reduzieren dadurch die an den Motorwicklungen zur Verfügung stehende elektrische Spannung.

Die Leistungskomponenten eines Elektromotors, insbesondere eines hochbeanspruchten Elektromotors in rauher Umgebung, z.B. in einem Kraftfahrzeug, erwärmen sich oft auf Temperaperaturen bis oberhalb 100°C. Um Überhitzung zu vermeiden, ist daher erforderlich, solche Leistungskomponenten zu kühlen, um deren frühzeitigen Ausfall vorzubeugen.

Andererseits besteht die Notwendigkeit, die Leistungskomponenten wie auch die Steuerkomponenten des Elektromotors auf elektrisch isolierenden Leiterplatten unterzubringen und miteinander zu verschalten. Die Substrate herkömmlicher Leiterplatten werden daher gewöhnlich aus einem elektrisch gut isolierenden Kunststoff gefertigt. Ein solcher Kunststoff hat jedoch schlechte Wärmeleitfähigkeit.

Ein Leiterplattenmaterial, das sowohl elektrisch isoliert als auch die Wärme gut ableitet, ist bekannt (Firmendruckschrift "The T-Lam System - T-Guide for performance", Firma THERMAGON Inc., Ohio/USA, 16.11.1999).

Der Erfindung liegt die Aufgabe zugrunde, eine Anordnung zur Aufnahme der Leistungs- und Steuerelektronik eines Elektromotors zu schaffen, welche den Anforderungen einerseits einer guten Wärmeabfuhr der in den Leistungskomponenten erzeugten Wärme und andererseits einer guten elektrischen Isolation sowohl der Leistungskomponenten als auch der Steuerkomponenten mit einer einfachen, raumsparenden und kostengünstigen Konstruktion gerecht wird.

Zur Lösung dieser Aufgabe ist eine Gehäuseanordnung gemäß Anspruch 1 vorgesehen.

Durch die erfindungsgemäße Trennung der Leistungskomponenten von den Steuerkomponenten und Anordnung dieser beiden Komponentengruppen im Abstand voneinander auf zwei gesonderten Leiterplatten unterschiedlicher Konsistenz sowie Zuordnung eines Kühlelementes nur zu der die Leistungskomponenten tragenden Leiterplatte ist die Aufgabe mittels einer überraschend einfachen und billigen Konstruktion gelöst, wobei, aufwendiges Leiterplattenmaterial kostensparend nur für die zweite Leiterplatte und nicht für die erste Leiterplatte eingesetzt ist, welche aus üblichem Leiterplatten-Kunststoff bestehen kann, welcher zwar gut elektrisch isoliert, jedoch Wärme schlecht abführt.

Die Erfindung erreicht einerseits eine gute thermische Anbindung der Leistungshalbleiter an den Kühlkörper und hat andererseits den Vorteil der weitgehenden thermischen Entkopplung von Leistungselektronik und Steuerelektronik. Die sich stärker erwärmende Leistungselektronik kann somit den Betrieb der Steuerelektronik nicht beeinflussen. Zusätzlich ergibt sich eine sehr kompakte Bauweise für die gesamte Elektronikbaugruppe, die in dem Elektromotor ein geringes Bauvolumen beansprucht. Die erfindungsgemäße Anordnung ist ferner fibrationsfest, insbesondere da keine eigenen Verbindungen über die Phasenwicklungen und die Steuerleitungen notwendig sind.

Die beiden Leiterplatten werden vorzugsweise nicht über die dem Stand der Technik bekannte Kabelstecker-Technik verbunden, sondern durch Verwendung spezieller Leistungshalbleitergehäuse, bei denen die Anschlußbeine der Leistungshalbleiter nach Bedarf gebogen werden können.

Bei einer Weiterbildung der Erfindung, ist die erste Leiterplatte oberhalb der Kupferschicht der zweiten Leiterplatte mit Abstand davon und im wesentlichen parallel dazu angeordnet ist. Die Kunststoffschicht der ersten Leiterplatte kann in vorteilhafter Weise zweiseitig mit einer Kupferschicht bedeckt sein, so daß auch auf der Unterseite dieser Leiterplatte Leiterbahnen ausgebildet sein können, was Platz spart und trotz der Anordnung der Leistungs- und Steuerkomponenten auf verschiedenen Leiterplatten ein einfaches Zusammenschalten der Komponenten der gegenüberliegenden Leiterbahnen der beiden Leiterplatten und damit der elektronischen Komponenten ermöglicht.

Das Kühlelement, das vorzugsweise eine dickwandige Aluminiumplatte aufweist, ist nur an die zweite Leiterplatte direkt wärmeleitend angebunden, weil sich die auf der ersten Leiterplatte angeordneten Steuerkomponenten im Betrieb nicht wesentlich erwärmen und deshalb keiner besonderen Kühlung bedürfen.

Die zweite Leiterplatte wird als dreilagiger Aufbau aus einer Kupferschicht, einer thermisch gut leitenden, elektrisch gut isolierenden Keramikschicht und einer Metallschicht ausgeführt, wobei für die Metallschicht Aluminium oder eine Aluminiumlegierung, das Wärme gut leitet, einzusetzen ist.

Ein bevorzugtes Leiterplattenmaterial dieser Art ist in der genannten Firmendruckschrift beschrieben und unter der Bezeichnung "Thermagon IMpcb" im Handel erhältlich.

Weitere vorteilhafte Ausgestaltungen der Erfindung sind in den weiteren Unteransprüchen angegeben.

Die Erfindung ist im folgenden anhand einer schematischen Zeichnung an einem Ausfiihrungsbeispiel mit weiteren Einzelheiten näher erläutert.

In den Figuren zeigen:
- Figur 1: ein schematisches Schaltbild einer Ansteuerelektronik eines dreiphasigen Gleichstrommotors;
- Figur 2: ein schematisches Blockdiagramm des grundsätzlichen Aufbaus der erfindungsgemäßen Anordnung;
- Figur 3: eine bevorzugte Ausführungsform einer Gehäuseanordnung gemäß der Erfindung in einer teilweise geschnittenen Darstellung; und
- Figur 4: eine Anordnung mehrerer Leistungstransistoren, wie sie in der Erfindung verwendet werden können.

Fig. 1 zeigt ein schematisches Schaltbild einer Ansteuerelektronik für einen dreiphasigen Gleichstrommotor. Der Gleichstrommotor umfaßt drei Phasenwicklungen U, 112; V, 114; W, 116, die in Fig. 1 schematisch in Sternschaltung 110 dargestellt sind. Die drei Wicklungen 112, 114, 116 sind zwischen einer positiven Versorgungsschiene 118 und einer negativen Versorgungsschiene 120 angeschlossen. Die positive Versorgungsschiene 118 führt das Potential +U_{BAT}, und die negative Versorgungsschiene 120 führt das Potential -U_{BAT}. Die Phasenwicklungen 112, 114, 116 werden über sechs Leistungs-Schaltbauteile T1, 122; T2, 124; T3, 126; T4, 128; T5, 130; T6, 132 nach Maßgabe von Steuersignalen mit den Versorgungsschienen 118, 120 verbunden. Die Leistungs-Schaltbauteile 122 bis 132 sind vorzugsweise Leistungstransistoren. Sie weisen Steueranschlüsse auf, die in Fig. 1 mit G1 bis G6 bezeichnet sind. Die Steueranschlüsse entsprechen insbesondere den Gates der Leistungstransistoren. Durch Anlegen geeigneter Steuersignale an die Gates der Leistungstransistoren werden die Phasenwicklungen 112 bis 116 des Gleichstrommotors bestromt, um dessen Betrieb zu steuern. Verfahren zum Steuern eines bürstenlosen elektronisch kommutierten Gleichstrommotors sind beispielsweise beschrieben in DE 100 33 561 A1 und U.S. 6,400,109 B1, auf die Bezug genommen wird.

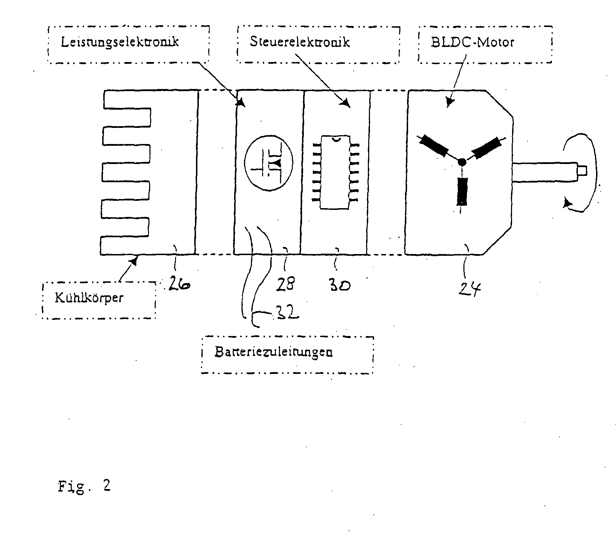

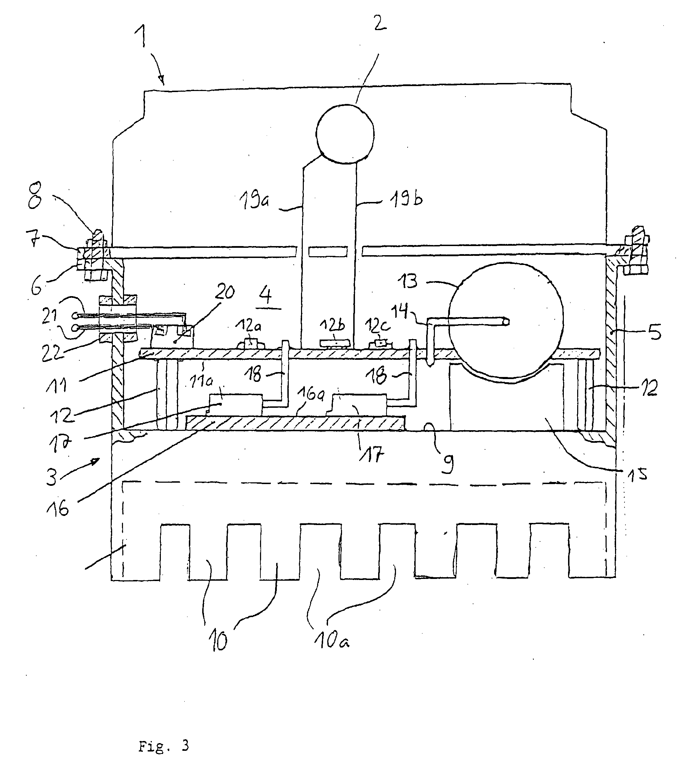

Fig. 2 zeigt schematisch in Form eines Blockdiagramms den grundsätzlichen Aufbau der erfindungsgemäßen Anordnung. In Fig. 2 bezeichnet das Bezugszeichen 24 einen bürstenlosen, elektronisch Gleichstrommotor, 26 einen Kühlkörper, 28 die Leistungselektronik und 30 die Steuerelektronik. Batteriezuleitungen sind mit 32 bezeichnet. Der in Fig. 2 schematisch dargestellte Aufbau gemäß der Erfindung ist mit weiteren Einzelheiten in Fig. 3 gezeigt.

In Figur 3 bezeichnen die Bezugszahlen 1 ein Motorgehäuse, 2 einen Elektromtor, 3 einen Kühlkörper aus Aluminium und 4 einen Aufnahmeraum für die Leistungs- und Steuerelektronik des Motors 2.

Der Aufnahmeraum 4 ist von einer zylindrischen Wand 5 umschlossen, welche von dem Kühlkörper 3 einstückig nach oben ragt und in einem oberen Ringflansch 6 endet, der mit einem unteren Ringflansch 7 des Motorgehäuses 1 über Schrauben 8 dicht verschraubt ist.

Der Aufnahmeraum 4 hat einen vom Kühlkörper innerhalb der zylindrischen Wand 5 gebildeten Boden 9 und an seiner Unterseite um den Umfang gleichmäßig verteilte Kühlrippen 10, deren Zwischenräume 10a von Umgebungsluft durchströmt sind.

Innerhalb des Aufnahmeraumes ist eine erste Leiterplatte 11 über Abstandhalter 12 am Boden 9 abgestützt. Diese erste Leiterplatte 11 hat herkömmlichen Aufbau mit einer Substratschicht aus einem harten, elektrisch isolierenden, die Wärme schlecht leitenden Kunststoff, zum Beispiel PTFE, und einer ein- oder beidseitigen Kupferbeschichtung zur Ausbildung von Leiterbahnen in üblicher Weise auf der Oberseite und gegebenenfalls auch auf der Unterseite der Substratschicht.

Bei einer alternativen Ausführungsform der Erfindung kann die Leiterplatte 11 anstatt durch die Abstandhalter 12 auch über einen Sockel oder eine andere Haltevorrichtung, die fest mit der zylindrischen Wand 5 des Kühlkörpers 3 verbunden ist, gelagert sein. Die Leiterplatte 11 kann beispielsweise über eine Schraube an einem solchen Sockel befestigt werden. Alternativ könnte die Leiterplatte 11 auch in einer entsprechenden Ausnehmung in der Wand 5 aufgenommen sein. Diese Ausführungsform hat den Vorteil einer besonders vibrationsfesten Lagerung der Leiterplatte 11.

Die Leiterplatte 11 trägt auf Ihrer Oberseite Steuerelektronik-Komponenten 12a, 12b, 12c. Ferner ist eine Kondensator in einer Öffnung der Leiterplatte aufgenommen und elektrisch mit dieser über Anschlußbeine 14 verbunden, die mit der Unterseite der Leiterplatte 11 verlötet sind. Der Kondensator 13 ist über eine metallische Abstützung 15 direkt am metallischen Boden 9 des Kühlkörpers 3 abgestützt, so daß die im Kondensator erzeugte Wärme direkt über die Abstützung 15 an den Kühlkörper 3 abgeleitet wird.

Am Boden 9 ist ferner eine Leiterplatte 16 befestigt, die einen dreilagigen Aufbau mit einer oberen Kupferschicht, einer Isolierschicht aus elektrisch isolierendem, die Wärme gut leitendem Keramikmaterial und einer Trägerschicht aus einem die Wärme gut leitenden Metall, wie Aluminium oder einer Aluminiumlegierung, hat. Auf die Oberseite dieser Leiterplatte sind mehrere Leistungselektronik-Gehäuse 17 angelötet, die über abgeknickte Anschlußbeine 18 mit der ersten Leiterplatte 11 verlötet sind. In den Leistungselektronik-Gehäusen 17 sind die üblichen Leistungselektronik-Komponenten gekapselt untergebracht.

Von der Oberseite der Leiterplatte 11 sind Anschlußleitungen 19a, 19b zum Motor 2 geführt. Diese umfassen in der Praxis Signalleitungen und Stromleitungen. Ferner ist ein Stecker 20 für Batteriezuleitungen 21 auf der Leiterplatte 11 vorgesehen, die über eine Durchführung 22 durch die Wand 5 aus dem Innenraum 4 herausgeführt sind.

Mit der beschriebenen Anordnung werden die im Betrieb sich erhitzenden Bauteile, nämlich in erster Linie die Leistungselektronik-Gehäuse 17 mit den darin befindlichen Leistungselektronik-Komponenten und auch der Kondensator 13 durch direkte Anbindung an den Kühlkörper 3 so gekühlt, daß eine unzulässige Überhitzung dieser Komponenten vermieden ist.

Durch die Anordnung der Steuerelektronik-Komponenten 12a - 12c auf einer herkömmlichen, billigen Leiterplatte ist teures Leiterplattenmaterial, wie dasjenige der Leiterplatte 16, eingespart. Die Anordnung der Leiterplatten 11, 16 wie gezeigt und beschrieben übereinander im Innenraum 4 ist Platz sparend.

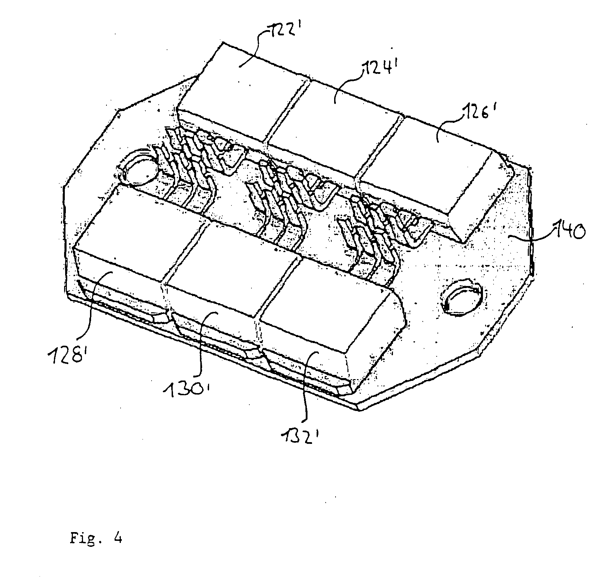

Figur 4 zeigt schematisch die Anordnung der Leistungstransistoren, beispielsweise der Transistoren 122' - 132' aus Fig. 1 auf einer Trägerplatte, beispielsweise der zweiten Leiterplatte 16. Die Leistungstransistoren weisen jeweils ein Leistungselektronik-Gehäuse und Anschlußbeine auf, die direkt mit der ersten Leiterplatte 11 verbunden werden können.

Insgesamt führt die Anordnung gemäß der Erfindung zu einer auch in rauhem Einsatz, zum Beispiel in einem Kraftfahrzeug, des Elektromotors 2 zu einem zuverlässigen Dauerbetrieb in einer kompakten, unempfindlichen Gesamtkonstruktion.

Die in der obigen Beschreibung, der Figur und den Ansprüchen offenbarten Merkmale können sowohl einzeln als auch in beliebiger Kombination für die Verwirklichung der Erfindung von Bedeutung sein.

### Bezugszeichenliste

- 1: Motorgehäuse
- 2: Elektromotor
- 3: Kühlkörper
- 4: Aufnahmeraum
- 5: zylindrische Wand
- 6: Ringflansch des Kühlkörpers
- 7: Ringflansch des Motorgehäuses
- 8: Schrauben
- 9: Boden
- 10: Kühlrippen
- 10a: Zwischenräume
- 11: erste Leiterplatte
- 12: Abstandshalter
- 12a, 12b, 12c: Steuerelektronik-Komponenten
- 13: Kondensator
- 14: Anschlußbein
- 15: metallische Abstützung
- 16: zweite Leiterplatte
- 17: Leistungselektronik-Gehäuse
- 18: Anschlußbein
- 19a, 19b: Motor-Anschlußleitungen
- 20: Stecker für Batteriekabel
- 21: Batteriezuleitungen
- 22: Durchführung
- 24: Gleichstrommotor
- 26: Kühlkörper
- 28: Leistungselektronik
- 30: Steuerelektronik
- 32: Batteriezuleitungen
- 110: Sternschaltung
- 112: Phasenwicklung U
- 114: Phasenwicklung V
- 116: Phasenwicklung W
- 118: positive Versorgungsschiene
- 12: negative Versorgungsschiene
- 122/122': Leistungs-Schaltbauteil T1
- 124/124': Leistungs-Schaltbauteil T2
- 126/126': Leistungs-Schlatbauteil T3
- 128/128': Leistungs-Schaltbauteil T4
- 130/130': Leistungs-Schaltbauteil T5
- 132/132': Leistungs-Schaltbauteil T6
- G1: Steueranschluß
- G6: Steueranschluß

## Patentansprüche

1. Anordnung zur Unterbringung der Leistungs- und Steuerelektronik eines Elektromotors (2), umfassend
- eine erste Leiterplatte (11), die mit Steuerelektronik-Komponenten (12a-12c) bestückt ist,
- eine zweite Leiterplatte (16), die mit Leistungselektronik-Komponenten (17) bestückt ist und ein elektrisch isolierendes, jedoch die Wärme gut ableitendes Substrat aufweist;
- ein mit dem Substrat der zweiten Leiterplatte (16) wärmeleitend in Kontakt stehendes Kühlelement (3),
**dadurch gekennzeichnet, daß** die zweite Leiterplatte (16) einen dreilagigen Aufbau mit einer Kupferschicht, einer damit in Kontakt stehenden Trägerschicht aus einem Keramikmaterial, das hohe Wärmeleitfähigkeit und gute dielektrische Isoliereigenschaften besitzt, und einer Metallschicht aus Aluminium oder einer Aluminiumlegierung, welche mit der Trägerschicht wärmeleitend verbunden ist, aufweist und daß die Metallschicht an das Kühlelement (3) wärmeleitend angebunden ist.

2. Anordnung nach Anspruch 1, **dadurch gekennzeichnet, daß** das Kühlelement einen Kühlkörper aufweist, der großflächig in wärmeleitendem Kontakt mit der Metallschicht steht und aus Metall besteht, vorzugsweise aus Aluminium.

3. Anordnung nach Anspruch 1 oder 2, **dadurch gekennzeichnet, daß** die erste Leiterplatte (11) eine Kupferschicht auf einer Substratschicht aus elektrisch isolierendem Kunststoff aufweist und im Abstand von der zweiten Leiterplatte (16) angeordnet ist.

4. Anordnung nach Anspruch 3, **dadurch gekennzeichnet, daß** die erste Leiterplatte (11) oberhalb der zweiten Leiterplatte (16) im wesentlichen parallel dazu angeordnet ist.

5. Anordnung nach Anspruch 3 oder 4, **dadurch gekennzeichnet, daß** die Substratschicht der ersten Leiterplatte (11) zweiseitig von Kupferschichten bedeckt ist, und daß die auf der unteren Kupferschicht (11a) ausgebildeten Leiterbahnen mit den Leistungselektronik-Komponenten (17) auf der gegenüberliegenden Oberseite (16a) der zweiten Leiterplatte verschaltet sind.

6. Anordnung nach einem der Ansprüche 3 bis 5, **dadurch gekennzeichnet, daß** ein an der zweiten Leiterplatte (16) angelötetes Leistungselektronik-Gehäuse (17) davon abgeknickte Anschlußbeine (18) aufweist, die mit der mit den Steuerkomponenten (12a-12c) bestückten ersten Leiterplatte (11) verlötet sind.

7. Anordnung nach einem der Ansprüche 2 bis 6, **dadurch gekennzeichnet, daß** die erste Leiterplatte (11) direkt auf dem Kühlkörper (3) mittels Abstandhaltern (12) abgestützt ist.

8. Anordnung nach einem der Ansprüche 2 bis 6, **dadurch gekennzeichnet, daß** die erste Leiterplatte (11) an einer Wand (5) des Kühlkörpers (3) unmittelbar abgestützt ist, wobei an der Wand (5) des Kühlkörpers (3) Verankerungsmittel für die Leiterplatte (11) vorgesehen sind.

9. Anordnung nach einem der Ansprüche 2 bis 8, **dadurch gekennzeichnet, daß** der Kühlkörper (3) einen Aufnahmeraum (4) für die erste (11) und die zweite Leiterplatte (16) einschließlich der darauf befindlichen Komponenten aufweist und über einen umgebenden Flansch (6) mit einem Gegenflansch (7) des Motorgehäuses (1) verbunden ist.

10. Anordnung nach einem der Ansprüche 2 bis 9, **dadurch gekennzeichnet, daß** der Kühlkörper (3) Kühlrippen (10) aufweist, deren Zwischenräume von Umgebungsluft durchströmbar sind.

11. Anordnung nach einem der Ansprüche 2 bis 10, **dadurch gekennzeichnet, daß** der Kühlkörper (3) aus Aluminium oder einer Aluminiumlegierung besteht.

12. Anordnung nach einem der vorangegangen Ansprüche, **gekennzeichnet durch** ein mit dem Kühlelement (3) verbundenes Motorgehäuse (1).

## Claims

1. An arrangement to accommodate the power and control electronics of an electric motor (2), comprising
- a first circuit board (11) mounted with control electronic components (12a-12c)
- a second circuit board (16) mounted with power electronic components (17) which has a substrate that not only has electrically insulating properties but also good thermal conductivity;
- a cooling element (3) in thermally conductive contact with the substrate of the second circuit board (16),
**characterized in that** the second circuit board (16) has a three-layer construction with a copper layer, a base layer in contact with the copper layer, the base layer made of a ceramic material having high thermal conductivity and good dielectric insulating properties, and a metal layer made of an aluminum or an aluminum alloy which conducts heat well and is connected to the base layer in a thermally conductive way, and that the metal layer is in thermal conductive contact with the cooling element (3).

2. An arrangement according to claim 1, **characterized in that** the cooling element has a heat sink which is in extensive surface contact with the metal layer in a thermally conductive way and is made of metal, preferably of aluminum.

3. An arrangement according to one of the claim 1 or 2, **characterized in that** the first circuit board (11) has a copper layer on a substrate layer made of electrically insulating plastic and is arranged spaced apart from the second circuit board (16).

4. An arrangement according to claim 3, **characterized in that** the first circuit board (11) is arranged above and essentially parallel to the second circuit board (16).

5. An arrangement according to claim 3 or 4, **characterized in that** the substrate layer of the first circuit board (11) is covered with copper layers on two sides and that the tracks formed on the lower copper layer (11a) are connected to the power electronic components (17) on the topside (16a) of the second circuit board located opposite.

6. An arrangement according to one of the claims 3 to 5, **characterized in that** a power electronic housing (17) soldered onto the second circuit board (16) has bent connecting pins (18) which are soldered to the first circuit board (11) mounted with the control components (12a-12c).

7. An arrangement according to one of the claims 2 to 6, **characterized in that** the first circuit board (11) is supported directly on the heat sink (3) by means of spacers (12).

8. An arrangement according to one of the claims 2 to 6, **characterized in that** the first circuit board (11) is directly supported on a wall (5) of the heat sink (3), bracing means for the circuit board (11) being provided on the wall (5) of the heat sink (3).

9. An arrangement according to one of the claims 2 to 8, **characterized in that** the heat sink (3) has an accommodating space (4) for the first (11) and the second circuit board (16) including the components located on them and is connected via a surrounding flange (6) to a counter flange (7) of the motor housing (1).

10. An arrangement according to one of the claims 2 to 9, **characterized in that** the heat sink (3) has cooling fins (10) and that air can flow through the spaces between the cooling fins (10).

11. An arrangement according to one of the claims 2 to 10, **characterized in that** the heat sink (3) is made of aluminum or an aluminum alloy.

12. An arrangement according to one of the above claims, **characterized by** a motor housing (1) connected to the cooling element (3).

## Revendications

1. Disposition de logement de l'électronique de puissance et de commande d'un moteur électrique (2), comprenant
- une première carte de circuits imprimés (11), qui est garnie avec des composants d'électronique de commande (12a-12c),
- une deuxième carte de circuits imprimés (16), qui est garnie avec des composants d'électronique de puissance (17) et présente un substrat électriquement isolant, mais bon conducteur de la chaleur;
- un élément de refroidissement (3) en contact de conduction de chaleur avec le substrat de la deuxième carte de circuits imprimés (16),
**caractérisée en ce que** la deuxième carte de circuits imprimés (16) présente une structure à trois couches avec une couche de cuivre, une couche de support, en contact avec la première, en matériau céramique ayant une conductibilité thermique élevée et de bonnes caractéristiques d'isolation diélectrique, et une couche métallique en aluminium ou en alliage d'aluminium, laquelle est reliée de manière conduisant la chaleur à la couche de support, et **en ce que** la couche métallique est reliée de manière conduisant la chaleur à l'élément de refroidissement (3).

2. Disposition suivant la revendication 1, **caractérisée en ce que** l'élément de refroidissement présente un dissipateur de chaleur qui est sur une grande surface en contact conduisant la chaleur avec la couche métallique et est en métal, de préférence en aluminium.

3. Disposition suivant la revendication 1 ou 2, **caractérisée en ce que** la première carte de circuits imprimés (11) présente une couche de cuivre sur une couche de substrat en matière plastique électriquement isolante et est disposée à distance de la deuxième carte de circuits imprimés (16).

4. Disposition suivant la revendication 3, **caractérisée en ce que** la première carte de circuits imprimés (11) est disposée au-dessus de la deuxième carte de circuits imprimés (16), essentiellement parallèlement à celle-ci.

5. Disposition suivant la revendication 3 ou 4, **caractérisée en ce que** la couche de substrat de la première carte de circuits imprimés (11) est recouverte des deux côtés de couches de cuivre et **en ce que** les pistes conductrices formées sur la couche de cuivre inférieure (11a) sont connectées aux composants de l'électronique de puissance (17) sur la face supérieure opposée (16a) de la deuxième carte de circuits imprimés.

6. Disposition suivant l'une des revendications 3 à 5, **caractérisée en ce qu'**un boîtier d'électronique de puissance (17) brasé sur la deuxième carte de circuits imprimés (16) présente des pattes de raccordement (18) repliées pour s'en écarter, qui sont brasées à la première carte de circuits imprimés (11) garnie des composants de commande (12a-12c).

7. Disposition suivant l'une des revendications 2 à 6, **caractérisée en ce que** la première carte de circuits imprimés (11) s'appuie directement sur le dissipateur de chaleur (3) à l'aide de pièces d'écartement (12).

8. Disposition suivant l'une des revendications 2 à 6, **caractérisée en ce que** la première carte de circuits imprimés (11) s'appuie directement sur une paroi (5) du dissipateur de chaleur (3), des moyens d'ancrage pour la carte de circuits imprimés (11) étant prévus sur la paroi (5) du dissipateur de chaleur (3).

9. Disposition suivant l'une des revendications 2 à 8, **caractérisée en ce que** le dissipateur de chaleur (3) présente un logement (4) pour la première (11) et la deuxième cartes de circuits imprimés (16) y compris les composants se trouvant sur celles-ci et est relié via une bride périphérique (6) à une contre-bride (7) du carter du moteur (1).

10. Disposition suivant l'une des revendications 2 à 9, **caractérisée en ce que** le dissipateur de chaleur (3) présente des ailettes de refroidissement (10), dans les espaces intermédiaires desquelles l'air ambiant peut circuler.

11. Disposition suivant l'une des revendications 2 à 10, **caractérisée en ce que** le dissipateur de chaleur (3) est réalisé en aluminium ou en alliage d'aluminium.

12. Disposition suivant l'une des revendications précédentes, **caractérisée par** un carter du moteur (1) relié à l'élément de refroidissement (3).
